(19) Europäisches Patentamt
European Patent Office
Office européen des brevets

(11) **EP 2 357 421 A2**

(12) **EUROPEAN PATENT APPLICATION**

(43) Date of publication:
**17.08.2011 Bulletin 2011/33**

(51) Int Cl.:
***F24F 3/044*** *(2006.01)*

(21) Application number: **11152954.1**

(22) Date of filing: **01.02.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **01.02.2010 GB 1001575**

(71) Applicant: **Hitec Air Conditioning Services Limited Tadley Basingstoke Hampshire RG26 5PX (GB)**

(72) Inventor: **Hudson, Alan Basingstoke, Hampshire RG26 3TF (GB)**

(74) Representative: **Treleven, Colin Optimus Patents Limited Grove House Lutyens Close Chineham Court Basingstoke, RG24 8AG (GB)**

(54) **Air cooling system**

(57)  An air cooling system (400) for a building comprises an air handling unit (410) producing cooling air (460) at a predetermined temperature. The cooling air (460) is supplied to a space (570) in the building. A mixing chamber (420) is adapted to supply air to the air handling unit (410). The mixing chamber (460) and ducting (64) may be retrofitted to a preexisting air handling unit in the building.

A first opening (430) in the mixing chamber allows entry of a first stream of air (480) from the space, at a temperature above the predetermined temperature. A second opening (435) in the mixing chamber allows entry of a second stream of ambient air (490) from outside the building.

The cooling system of the invention reduces energy consumption.

Fig. 4

EP 2 357 421 A2

**Description**

**Field of the Invention**

The invention concerns air cooling systems for buildings. The invention may be used with a close control cooling system, but is not limited to this application.

**Background of the Invention**

Many buildings, or parts of buildings, require active control of the temperature of the air within them. Examples include computer rooms, UPS (Uninterruptible Power Source) rooms, research laboratories, food processing factories and computer chip manufacturing facilities. In addition, many buildings in hotter regions of the world have ducted air cooling systems to eliminate peaks of temperature.

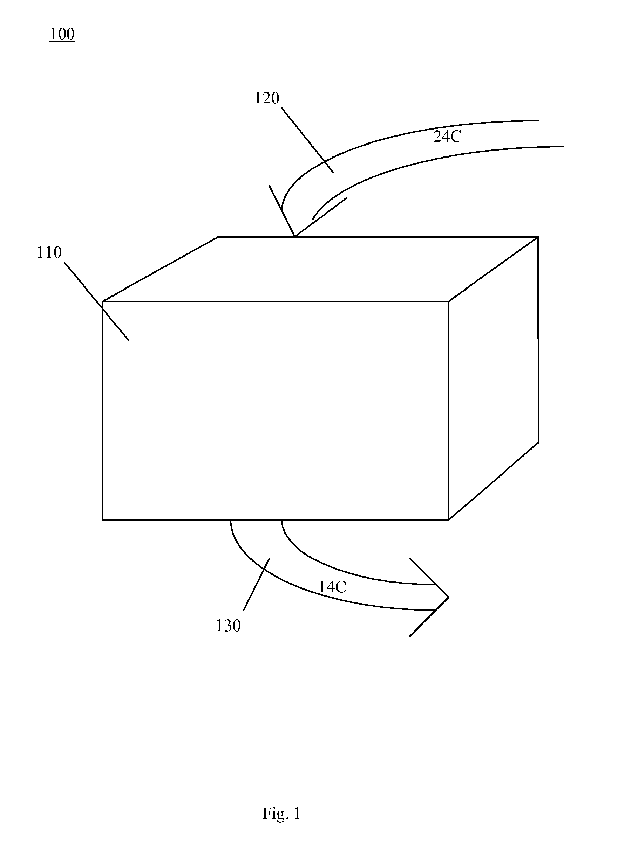

One known approach to cooling is to use a Close Control Cooling System'. Figure 1 shows a known arrangement of one component of such a system.

Figure 1 shows a perspective view 100 of an air handling unit 110, and the general direction of the flows of air to and from air handling unit 110. Air handling unit 110 serves to cool the air that is supplied to it.

Reference 120 indicates an input stream of air arriving at air handling unit 110. If input air stream 120 is from a computer room, for example, then it may typically be at a temperature of 24 degrees Centigrade. Air from a computer room would have been warmed both by the heat generated by computers in use, and heat from any occupants of the room. In addition, air is warmed by 'building loads'. These loads include heat from walls and roofs, and solar gain through windows.

Air handling unit 110 provides, as its output, a stream of cooling air 130. Cooling air stream 130 may be at, for example, 14 degrees Centigrade.

In a known system, the rate of supply of cooling air may be controlled in order to ensure that conditions in the computer room are maintained as closely as possible to a target 'set point'.

Although not shown in the schematic representation of figure 1, the input 120 and cooling 130 airstreams may flow in ducts. This is the normal arrangement when air handling unit 110 is not located within the space whose temperature is to be controlled. The input airstream may be propelled along by extractor fans located in a room whose temperature is to be controlled.

If air handling unit 110 is located within the space whose temperature is to be controlled, then it may not require ducting for input airstream 120. Instead, input air stream 120 may simply flow into the top of air handling unit 110 through an opening.

It may be necessary to ensure an even distribution of cool air into the space whose temperature is to be controlled. In this case, cooling air stream 130 may, for example, be directed under the floor. The cooling air would then emerge into the space whose temperature is to be controlled via floor tiles with openings in them. Those openings may be fitted with grills that have dampers. So it is possible to adjust where air is sent, by adjusting the settings of the dampers. Alternatively, the locations of the tiles may be re-distributed.

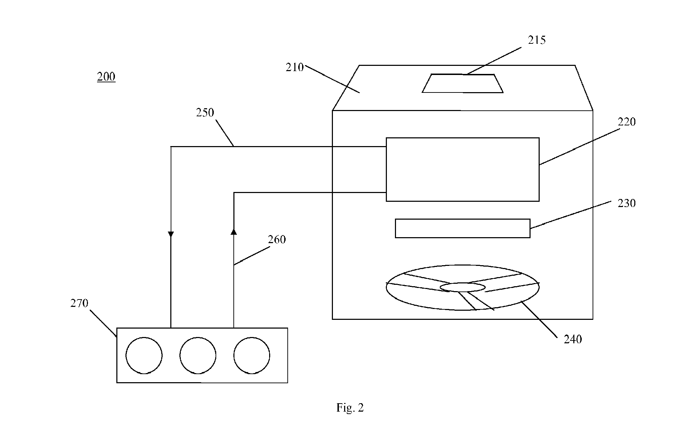

Figure 2 shows the detailed features of a known cooling system 200 that incorporates an air handling unit 210.

The flow of air to and from air handling unit 210 is as generally shown in figure 1. An opening 215 in the upper surface of air handling unit 210 allows entry of warm input air.

Inside air handling unit 210 are three main components:

(i) Cooling unit 220. Cooling unit 220 acts to lower the temperature of air flowing down through it. In a common design, cooling unit 220 will contain a metal coil, within which circulates a coolant fluid with a low boiling point. The coil may, for example, have a temperature of 4 degrees on its outer surface. Warm air, typically at 24 degrees Centigrade, enters the top of cooling unit 220 and comes into contact with the metal coil. The liquid within the coil evaporates, and the latent heat of evaporation to achieve this comes from the air. The air is thus cooled.

(ii) A re-humidifier 230. As the air cools in cooling unit 220, its relative humidity will normally fall. However, some applications of air handling units require the cooling air to have a particular relative humidity. Known cooling systems are often designed to achieve a target 'set point'. This set point may include both a target temperature and a target humidity in the space to be cooled, e.g. a target of 50% relative humidity.

The rate of supply of cooling air and the re-humidifier 230 may co-operate to achieve the set point. So the cooling air stream 130 in Figure 1 may be supplied, for example, at a temperature of 14C and a relative humidity somewhere in the range of 45%-50%.

(iii) A fan 240. Fan 240 may be a fixed rate fan. Alternatively, fan 240 may be a variable speed fan, which can then control the rate at which air is expelled at the bottom of unit 210. This therefore controls the rate of supply of cooling air stream 130.

When the coolant fluid in cooling unit 220 has evaporated to form a gas, it passes out of air handling unit 210 via pipe 250. Pipe 250 delivers the gas to condensing unit 270.

Condensing unit 270 is normally located outside of the building, in the fresh air. Condensing unit 270 is shown with a schematic representation of three fans. These blow ambient air through condensing unit 270. The condensing unit may house one or more compressors, which cause the coolant fluid to condense from its gaseous state, back to a liquid. The heat liberated by this process is conducted away by the ambient air forced into condensing unit 270 by the fans.

The liquid coolant is then supplied via pipe 260 back to the cooling unit 220 in air handling unit 210.

Although not shown in figure 2, air handling unit 210 normally also includes a heater. The heater provides the unit with the ability to heat the air flowing from it, should that be necessary.

A typical cooling system 200 may, for example, supply 300 cubic meters of cooling air per hour. In large buildings, there may be several cooling systems of the type shown in Figure 2. These may be of different kW capacities, e.g. one of 20kw, one of 40kw. The cooling systems may occupy various locations throughout the building.

Considering further a computer room as the example of the space whose temperature is to be controlled, it is clear that the temperature of the computer room can be controlled in various ways:

(i) The cooling system could be arranged to ensure that the compressor is shut off when the air in cooling air stream 130 has reached a temperature as low as perhaps 8 or 10 centigrade.

(ii) The compressor 270 might only run when there is hot gas arriving via pipe 250.

(iii) Typically, the fan 240 at bottom of air handling unit 210 is of fixed speed. However, the fans on the compressor 270 may be of variable speed. When the ambient air temperature is low, the fans in compressor 270 can be operated at low speed, and the compressor will still achieve sufficient cooling effect.

(iv) If fan 240 were a variable speed fan, then the temperature of the computer room could be varied by varying the rate at which cooling air stream 130 is supplied to the computer room by fan 240. Assuming for simplicity that the rate of heat generation in the computer room is constant, then the temperature of the computer room will fall, if the rate of supply of cooling air stream 130 to the computer room increases. Conversely, if the rate of supply of the cooling air stream 130 decreases, then the temperature of the computer room will rise.

Although not shown in figures 1 and 2, alternative forms of cooling system are known in which the air flows upwards through the air handling unit. The air intake is usually at floor level, with such a cooling system.

In addition, air handling units are known with an attached chamber. The chamber is often referred to as a 'plenum'. Air from a space to be cooled may flow through the chamber, prior to flowing into the air handling unit.

Prior art arrangements have attempted to reduce the amount of energy used by cooling systems such as those shown in figures 1 and 2. Two prior art arrangements are shown in published patent applications WO2008079138(A1) and WO2008082378(A1).

**Statement of Invention**

In accordance with a first aspect, the invention comprises a cooling system with the features of appended claim 1.

In accordance with a second aspect, the invention comprises a method of cooling with the steps of appended claim 11.

Dependent claims 2-10 and 12-15 provide details of preferred embodiments of the invention.

The mixing chamber of the invention may be retrofitted to a preexisting air handling unit in a building, to form an air cooling system. This has the advantage of increasing the energy performance of a pre-existing air handling unit, without requiring complete replacement of the air handling unit.

Ducting may be fitted to a building, to supply air from outside the building to each of one or more pre-existing and newly installed air handling units. Air handling units of differing ages, capacities and designs may thereby be integrated into a single air cooling system.

**Brief Description of the Drawings**

Figure 1 shows a perspective view 100 of an air handling unit known from the prior art.

Figure 2 shows a perspective view of an air handling unit and other components of a cooling system known from the prior art.

Figure 3 shows a perspective view of a cooling system in accordance with an embodiment of the invention.

Figure 4 shows an exploded perspective view of the embodiment of the invention shown in figure 3.

Figure 5 shows a schematic diagram of some details of a cooling system in accordance with the present invention.

Figure 6 shows a schematic diagram of a cooling system in accordance with the present invention.

Figure 7 shows a schematic diagram of a control protocol in accordance with an embodiment of the invention.

Figure 8 shows ambient air temperatures over a year in the UK.

## Description of Preferred Embodiments

Existing cooling systems, such as that shown in Figure 2, are often arranged to operate at all times. This means that they consume large amounts of energy. The condensing unit 270 shown in figure 2 may require 8 Amps to run the fans and controlling software, plus 60 Amps to run the compressors. The whole system shown in figure 2 may require 80 Amps.

Such a power demand may be effectively continuous, i.e. needed 24 hours per day, every day. However, there may be some portions of each hour when it is possible to recirculate air, and for this period the compressor may be switched off.

It is normal to install a cooling system that is 'oversized', which means that it has more cooling capacity than is likely to be needed. Such oversized systems can then be cycled on and off, except during periods of abnormally high demand. So, when the returned air from the space to be cooled is found to be at e.g. 21 Centigrade, compared to an expected value of 24 Centigrade, it is possible to turn off the cooling unit temporarily.

Some recent designs of cooling system offer the option of bringing air into a building from outside, when the temperature of the outside air is suitable to provide cooling. The space to be cooled may therefore be fed directly with cool air from outside, effectively bypassing the air handling unit. Bringing in air from outside a building may, for example, allow a cooling system such as that in figure 2 to be turned off, at least for short periods.

Even the latest designs of cooling system do not maximize the energy saving available from cooler outside air. Those designs may also not be suitable for 'retrofitting' to existing cooling systems, such as those of the design illustrated by figure 2.

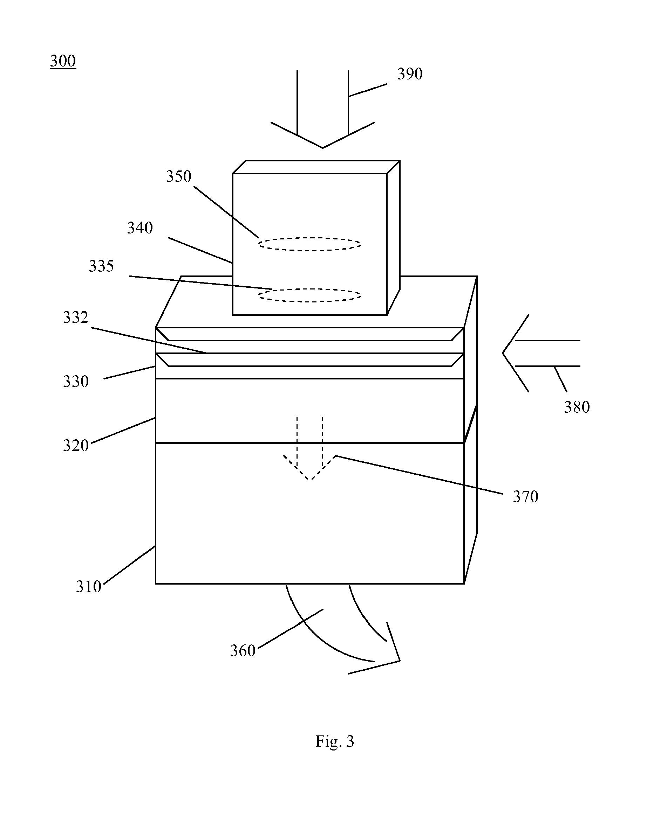

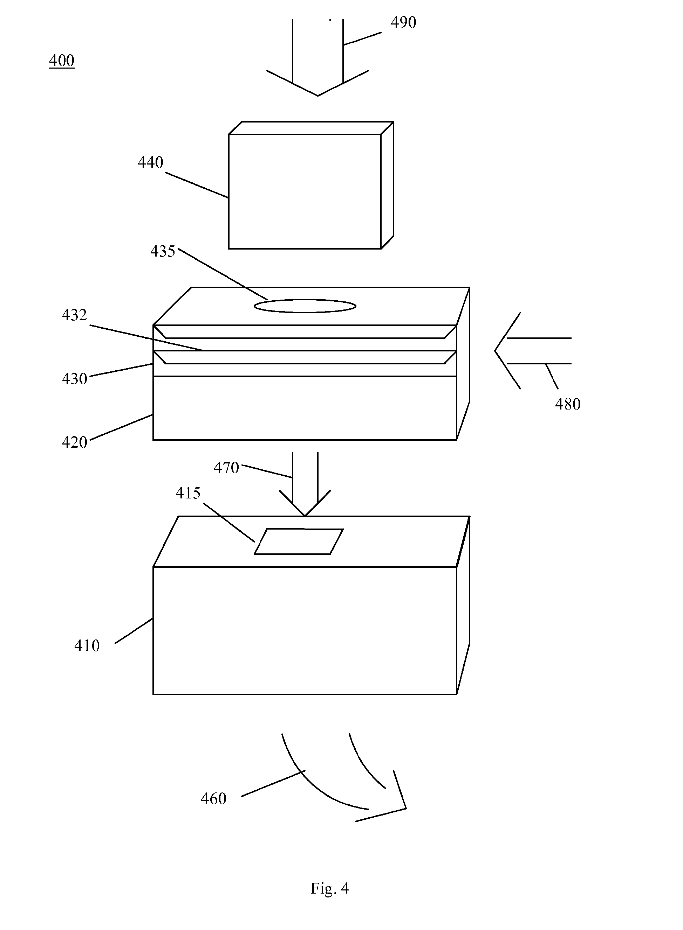

Figures 3 and 4 show different views of one embodiment of the present invention.

Figure 3 shows a perspective view of a cooling system 300 in accordance with an embodiment of the invention.

Cooling system 300 may be referred to as a 'free cooling system'. This is because it acts to provide cooling to a space in a building using freely available ambient air from the outside environment, as much as possible. It thereby reduces the amount of artificial, active cooling that needs to be provided by a condensing unit and cooling unit, such as condensing unit 270 and cooling unit 220 in figure 2.

Cooling system 300 comprises an air handling unit 310. Air handling unit 310 is adapted to produce cooling air at a predetermined temperature, for supply to a space in the building. The stream of cooling air 360 produced by air handling unit 310 is shown by the arrow at the lower part of figure 3.

The 'space' in the building may take a variety of forms. Typically, it might be a computer room, research laboratory or other room requiring stable, controllable or predictable conditions. The parameters of the space that need to be controlled may include temperature and humidity.

Air handling unit 310 may be of the type generally illustrated as unit 110 in figure 1 and unit 210 in figure 2. In this case, the invention may be applied to an existing air handling unit in a building. The rest of the components shown in figure 3 would simply be added as a 'retro-fit' to an existing air handling unit 310 that was already in use in a building. Alternatively, all the components shown in figure 3, including air handling unit 310, may be installed as a single new system.

Cooling system 300 further comprises a mixing chamber 320. An alternative term for mixing chamber 320 is a 'plenum'. Mixing chamber 320 is adapted to supply air to air handling unit 310. The air supplied from mixing chamber 320 to air handling unit 310 is generally indicated by arrow 370. Arrow 370 is shown dotted, because the air flow is located inside the units shown in figure 3, so would only normally be visible in a cut-away view.

Mixing chamber 320 comprises:

(i) A first opening 330. First opening 330 is located on the side of mixing chamber 320. First opening 330 allows entry into mixing chamber 320, selectably, of a first stream of air 380, which flows from the space whose temperature is to be controlled. First stream of air 380 is at a temperature above the predetermined temperature of the cooling air 360 supplied by air handling unit 310. In the embodiment of the invention shown in figure 3, the first opening 330 is covered by a variable damper 332. The two parallel elements of variable damper 332 are shown partially open. Variable damper 332 may be an electronically controlled damper.

(ii) A second opening 335. In the embodiment of the invention shown in figure 3, second opening 335 is obscured by the lower end of ducting 340, so is shown only by dotted lines. Second opening 335 allows entry into the chamber, selectably, of a second stream of air, which is indicated by arrow 390. Second stream of air 390 is ambient air from outside the building.

Ducting 340 conducts air from its upper end, which is open to the air outside the building, down into mixing chamber 320 via second opening 335. Ducting 340 incorporates a fan, whose location is generally indicated by reference 350. Once again, fan 350 is shown dotted, since it is located inside ducting 340 and would only be visible in a cut-away view.

Ducting 340 may typically contain one or more filters, which are not shown in figure 3. An air handling unit 310 may also itself normally contain up to four filters.

In an alternative embodiment of the invention, the function of fan 350 may be fulfilled by an uprated fan in air handling unit 310. Such an arrangement would normally require replacement of the standard fan fitted into an existing air handling unit 310. However, this arrangement eliminates the requirement for ducting 340 to have an additional fan 340.

Figure 4 provides an exploded perspective view of the components of figure 3, in order to allow a better understanding of how the various functional elements fit together.

Cooling system 400 of figure 4 comprises air handling unit 410, which provides a stream of cooling air 460 at a predetermined temperature. The upper surface of air handling unit 410 has an aperture 415. A stream of air 470 enters aperture 415 from mixing chamber 420.

Mixing chamber 420 has first opening 430 in its front surface. Variable damper 432 lies in first opening 430. First stream of air 480 enters mixing chamber 420 via first opening 430, from the space whose temperature is to be controlled.

The upper surface of chamber 420 has an aperture 435. Ducting 440 conducts second stream of air 490, which is ambient air from outside the building, as far as aperture 435.

In both figures 3 and 4:

(i) Damper 332, 432 allows control of the rate at which air from the space enters mixing chamber 320, 420. Damper 332, 432 therefore constitutes one means for selecting the volume flow rate of the first air stream 380, 480.
(ii) The volume flow rate of second air stream 390, 490 is selectable, by adjustment of the speed of fan 350 in duct 340, 440.

Damper 332, 432 and fan 350 therefore each act as selecting mechanisms. However, the invention could also be made to work with only fan 350 as a variable selecting mechanism.

In some embodiments of the invention, some air from the space would need to be vented to the outside, and hence would not then form part of first air stream 380, 480.

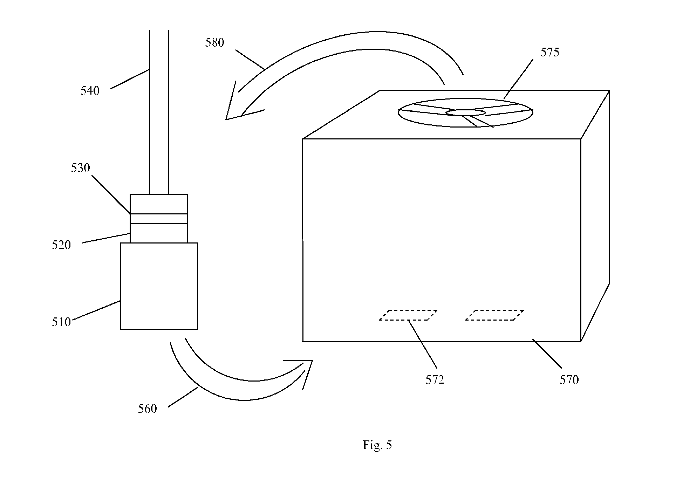

Figure 5 shows a schematic diagram of some details of a cooling system in accordance with the present invention.

Air handling unit 510 supplies cooling air stream 560 to space 570, which is shown in perspective view in figure 5. Cooling air stream 560 enters space 570 via openings 572 in the lower surface of space 570.

In figure 5, air handling unit 510 has been shown outside space 570. This serves to make figure 5 clearer. However, approximately 99% of air handling units currently installed in the UK are inside the space that they cool. Therefore, throughout this description, it should be understood that the air cooling system of the invention could equally well be installed in the space that it cools.

Fan 575 is located in the upper surface of space 570. Fan 575 extracts warm air from space 570, thereby creating first air stream 580.

Mixing chamber 520 is located on top of air handling unit 510. Duct 540 provides a conduit for ambient air from outside the building to reach mixing chamber 520. Duct 540 may contain a fan corresponding to fan 350 shown in figure 3.

An opening 530 in chamber 520 allows the entry of air from air stream 580, which may be brought to opening 530 by additional ducting that is not shown in figure 5.

Mixing chamber 530 does not need to be located on top of air handling unit 510, and could be located elsewhere. In that case, an additional duct would then be provided to conduct air from mixing chamber 520 to air handling unit 510.

Space 570 has fan 575 located at its highest point. This aids the removal of warm, used air from space 570. In practice, fan 575 may be either roof- or wall mounted.

A typical air handling unit 510 has a fan corresponding to fan 240 shown in figure 2. The fan at the base of air handling unit 510 is typically a 'paddle fan'. This fan is designed to operate with air in the air handling unit at zero Pascals of excess pressure. Another way of stating this is that the air handling unit is not designed to have air forced down through it. Instead, the fan in the base of the air handling unit provides any pressure necessary to:

(i) Force air through any channels or ducting, as far as the floor openings 572 in space 570 that is to be cooled; and
(ii) Provide any 'positive' pressure that is considered desirable in space 570.

In order to make sure that there is no pressure on the fan in the base of the air handling unit 510, it is necessary to control the amount of air fed into the top of the air handling unit 510. So the sum total of air fed by fan 575 through opening 530, and by the fan in duct 540, must balance the air flow 560 to space 570. In practice, if any ambient air is fed into air handling unit 510 through ducting 540, then some of the warm air from space 575 must be vented away, i.e. not pass through opening 530.

Considering a numerical example, assume that 25% of the air flow into air handling unit 510 is ambient air. The remaining 75% of the air flow into air handling unit 510 is warm air 580 from space 570. As a consequence, 25% of the air leaving the top of space 570 must be vented away, so that it does not enter mixing chamber 520. The venting may, for example, simply involve expelling the warm air from the building.

As an alternative to the arrangement shown in figure 5, air handling unit 510, mixing chamber 520 and ducting 540 may be located within space 570.

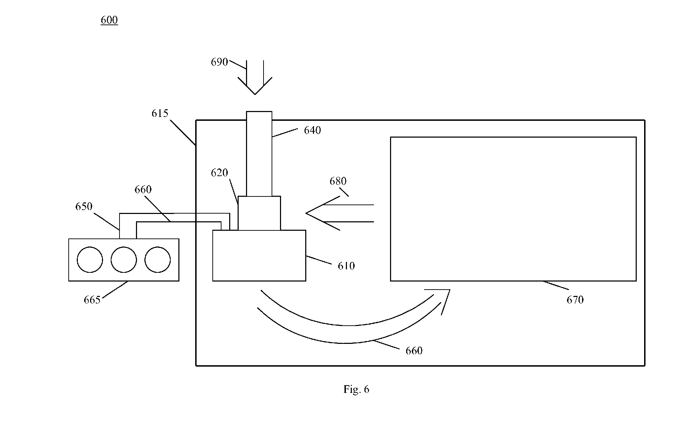

Figure 6 shows a schematic diagram of a cooling system 600 in accordance with the present invention. Figure 6 is similar to figure 5, but also shows the walls of the building and the external cooling unit.

An air handling unit 610 cools a space 670. Both air handling unit 610 and space 670 and are located within building 615.

Such systems as that shown in figure 6 are often referred to as a 'dx close control ahu'. Here the term 'dx' is an abbreviation of 'direct expansion', which refers to the direct expansion of refrigerant to provide a cooling effect. Such systems are typically designed to be able to provide control of heating, cooling and humidity.

Also located within building 615 are mixing chamber 620 and most of ducting 640. However, the upper portion of ducting 640 extends outside building 615, thereby allowing a flow of ambient air 690 to enter ducting 640.

Condensing unit 665 is also located outside building 615. Pipes 650 and 660 allow the circulation of coolant between air handling unit 610 and condensing unit 665.

In operation, air handling unit 610 produces cooling air 660 at a predetermined temperature, for supply to space 670 within building 615. A first stream of air 680 is supplied from space 670 to mixing chamber 620. First stream of air 680 is at a temperature above the predetermined temperature.

A second stream of air 690 enters mixing chamber 620 from outside building 615.

Although figures 3, 4, 5 and 6 have each shown one air handling unit, this may not be the case. Many existing buildings have more than one air handling unit. These may be of different ages, capacities and designs. The invention may be applied to such arrangements by providing ducting 640 which has branches to each air handling unit.

If the air handling units are widely spaced throughout the building, then each may be provided with a mixing chamber 620. So there would then be a unique plenum for each air handling unit. A system of ducting would then supply each mixing chamber. So a bespoke ducting system may be used for a particular building, linking various air handling units to roof and ceiling openings. One branch of the ducting system may then go to each mixing chamber. A fan may be located in each branch, and may be used to control the supply of ambient air to the mixing chamber that it supplies.

The invention may act to provide air cooling for a space inside a building, by supplying air to the air handling unit, the air handling unit providing cooling air at a predetermined temperature to the space, wherein:

(i) when ambient air outside the building is warmer than air extracted from the space, only a stream of air extracted from the space is supplied to the air handling unit;
(ii) when ambient air outside the building is cooler than air extracted from the space but warmer than the predetermined temperature, a mixture of a stream of air extracted from the space and a stream of ambient air from outside the building is supplied to the air handling unit;
(iii) when ambient air outside the building is cooler than the predetermined temperature, a mixture of a stream of air extracted from the space and a stream of ambient air from outside the building is supplied to the air handling unit, and the proportion of ambient air in the mixture is reduced as the temperature of the ambient air falls.

In step (ii), the proportion of ambient air in the mixture may be kept as close to 100% as possible. The proportion of air from the space may be kept to the minimum necessary to ensure the regulation of humidity in the space.

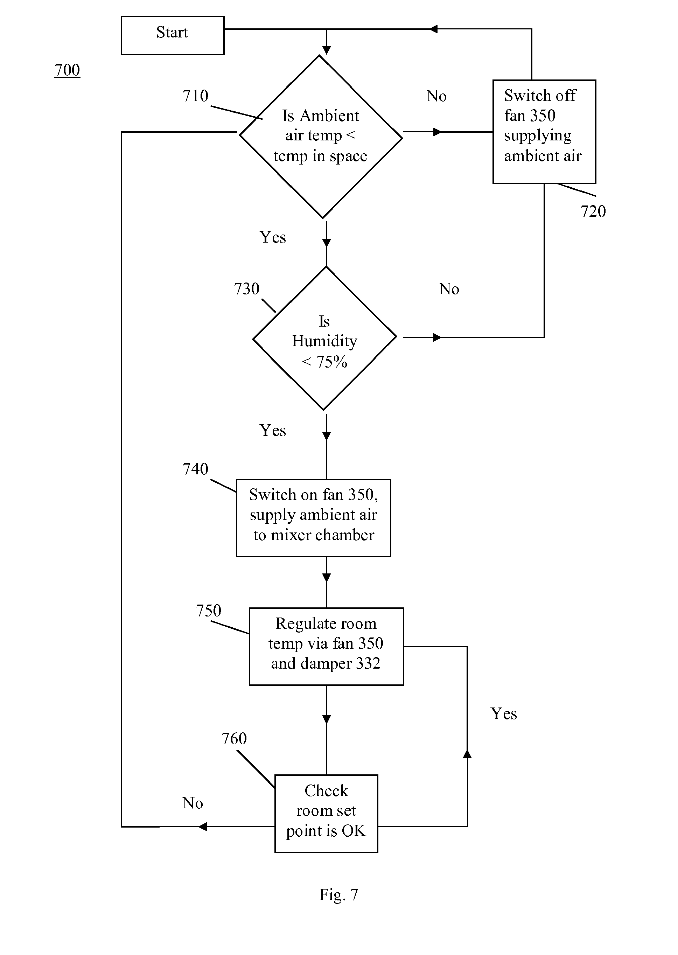

Figure 7 shows an example of a protocol 700 for operation of the invention.

In step 710, a check is made to see whether the air outside the building is at 24C or below. If the answer is No, then the method moves to box 720. The air handling unit then ceases, or does not start, taking in ambient air from outside the building.

If the answer to decision box 710 is Yes, then the method proceeds to box 730. A check is then made to see whether the humidity of the ambient air is below 75%. This is an illustrative example of a humidity threshold, which is likely to vary in dependence on the use of the space in the building. If the answer is No, then the method moves to box 720.

If the answer to decision box 730 is Yes, then the method moves to box 740. The air cooling system then switches on fan 350, to supply ambient air to the mixer chamber.

The method then moves to box 750. The method then regulates the temperature in the space to be cooled, by controlling the mixer damper 332. This continues as long as the room's set point is maintained, see box 760.

If the set point is not maintained, then the method returns from box 760 to decision box 710.

The control system of the present invention may utilize 'fuzzy logic'. As a consequence, the exact decision points used by the system may vary over time.

Table 1 below shows a sample of the selection of first and second air streams that may be implemented by the controller.

Three issues are relevant to Table 1, as follows:

(i) Table 1 shows a predetermined temperature of 14C. Other predetermined temperatures may be chosen. If the air cooling system is set to provide a stream of cooling air within a range of permissible temperatures, then the values in table 1 will change accordingly.

(ii) When ambient air is well below the predetermined temperature, in the bottom row of the table, there may be insufficient warm air available to keep the stream of air fed to the space at the right temperature. This will limit the amount of ambient air that can be used.

(iii) The set point for the space requires that humidity be kept within a given range. This requirement may also limit the amount of ambient air that can be used, for example if it is of very high humidity.

**Table 1: Supply of air to mixing chamber through first and second openings**

| Temperature of ambient air outside building | Supply of warm air 380, 480 through first opening 430 (Percentage of maximum possible) | Supply of outside air 390, 490 through second opening 435 (Percentage of maximum possible) |
|---|---|---|
| Greater than or equal to 24 Centigrade | 100 | 0 |
| Less than 24 Centigrade, but greater than or equal to 14 Centigrade | Low. May be as low as 0%, if set point, e.g. for humidity in space, can still be maintained. | Kept as high as possible, typically 90% or more. May be 100% if set point, e.g. for humidity in space, can be maintained. |
| Less than 14 Centigrade | Greater than 0%. Percentage rises as temperature of outside air falls | Less than 100%. Percentage falls as temperature of outside air falls |
| (Assumes that first (warm) air stream at 24 Centigrade, and that required predetermined Temperature for cooling air is 14 Centigrade) | | |

The system's operating characteristic may be divided into three portions. These are as follows, and match those defined in Table 1:

(i) When the temperature of the ambient air outside the building exceeds the temperature of the air extracted from the space. In this situation, there is no value in using air from outside. The speed of fan 350 in the ducting 340 supplying ambient air can be set to zero. Under these conditions, the air handling unit of figures 3 and 4 will therefore operate much as that shown in figures 1 and 2. Only first air stream 380, 480 enters mixing chamber 320, 420 and air handling unit 310, 410.

(ii) When the ambient air temperature is below the temperature of the air extracted from the space, but above the predetermined temperature. In this situation, fan 350 runs. It is advantageous for the air handling unit to use as high a proportion of ambient air from outside as possible. Consider an example where the ambient air in second airstream 390, 490 is at a temperature of 16 degrees Centigrade, and first airstream 380 is at 24 degrees Centigrade. Assume a predetermined temperature of 14 degrees Centigrade is required for cooling air 360, 460. In this case, the air in second airstream 390, 490 only needs to be cooled by 2 degrees Centigrade in order to achieve the target predetermined temperature. This requires much less energy than in prior art systems, since it reduces the power consumption by the condensing unit. In comparison, in prior art systems, all the air entering the air handling unit would be at 24 rather than 16 degrees Centigrade. The limit on the proportion of air taken from outside the building is likely to be determined by the humidity of that air, at any particular time.

(iii) When the ambient air temperature is below the predetermined temperature. In this case, air in second airstream 390, 490 entering the chamber is too cold for the target temperature of cooling air 360, 460. Heating elements in chamber 320, 420 could warm the air sufficiently to provide cooling air at the desired predetermined temperature. Alternatively, in some applications, it might be acceptable for cooling air below the predetermined temperature to be supplied to the space. This would need to be at a slower rate than would have been the case with air at the predetermined temperature, in order to achieve the same degree of cooling. However, the solution chosen in Table 1 is to allow a mixture of the first 380 and second 390 airstreams to flow from the chamber into air handling unit 310. This is achieved by selecting fan 350 to be working at less than full power, and damper 332, 432 to be less than fully open.

In the above example, it is clear that even ambient air at, for example, 20C could be used to achieve cooling. It would require less energy to cool ambient air at 20C down to the target temperature of 14C, than to cool air at 24C that is exiting the chamber, down to 14C.

Although the example above describes a situation where the target temperature for the space to be cooled is 14C, this is for simplicity of explanation. It is quite possible to set a range of temperatures as the target. So the cooling system might, for example, be arranged to provide cooling air 360, 460 at a temperature of between 8C and 15C. Any temperature of cooling air 360, 460 achieved within this range would be considered satisfactory. This would allow the cooling system to be switched off for some of the time.

Considering situation (iii) further, it is possible to calculate a possible operating characteristic for the situation where:

a) The predetermined temperature is 14 degrees Centigrade;
b) First airstream 380, 480 is at 24 degrees Centigrade; and
c) Second airstream 390, 490 is at various temperatures T below 14 degrees Centigrade.

Assume that the variable X is the proportion of all air entering mixing chamber 330, 430 that originates from outside the building. This is air at a temperature T degrees Centigrade below the predetermined temperature 14C.

Assume that the variable Y is the proportion of all air entering mixing chamber 330, 430 that originates from the space. This is air at 10 degrees Centigrade above the predetermined temperature for the cooling air.

Clearly, the two proportions X and Y must add to unity. This gives equation [1] as follows:

$$X + Y = 1 \qquad\qquad [1]$$

For the air entering air handling unit 320, 420 to be at 14 degrees Centigrade, then:

$$(T \times X) + (10 \times Y) = 0 \qquad\qquad [2]$$

Putting equation [1] into equation [2] gives:

$$(T \times (1-Y)) + (10 \times Y) = 0$$

The solution to this equation provides relation [3] below:

$$Y = T / (T-10) \qquad\qquad [3]$$

Table 2 below provides numerical values for the proportions X and Y, for temperatures T from 2 to 14 degrees below the predetermined Temperature.

| Difference between ambient air temperature and 14C (T degrees Centigrade) | Proportion Y of all the air entering mixing chamber that originates from first (warm) airstream 380,480 | Proportion X of all the air entering mixing chamber that originates from second (outside) airstream 390,490 |
|---|---|---|
| -2 | 0.17 | 0.83 |
| -4 | 0.29 | 0.71 |
| -6 | 0.38 | 0.62 |
| -8 | 0.44 | 0.56 |
| -10 | 0.50 | 0.50 |
| -12 | 0.55 | 0.45 |
| -14 | 0.58 | 0.42 |

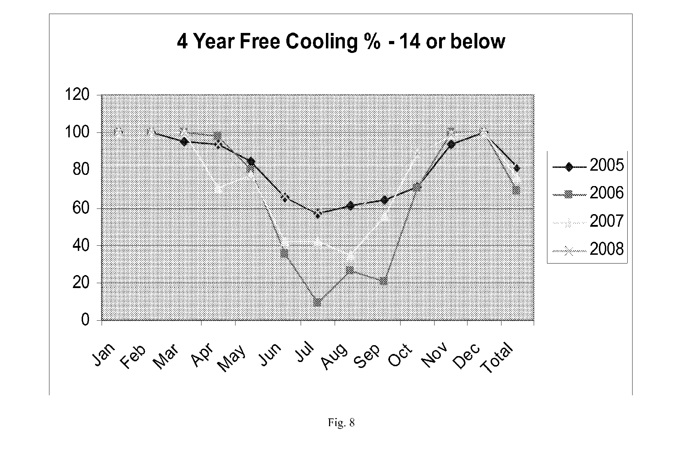

Figure 8 shows ambient air temperatures over each of years 2005-2008.

Figure 8 illustrates the percentage of time in each month of each of years 2005-2008 when ambient air was cooler than 14C. Such cool air can therefore be used by the method and system of the invention, and may reduce energy consumption in comparison to prior art systems.

Table 2 below shows the data on which figure 8 is based.

The data in Table 2 is from the UK. However, not all the data in Table 2 was recorded at the same locations within the UK.

**Table 2: Percentage of each month in years 2005-8 when ambient air temp was 14C or less**

| | Jan | Feb | Mar | Apr | May | Jun | |
|---|---|---|---|---|---|---|---|
| 2005 | 100 | 100 | 95.2 | 93.7 | 84.6 | 65 | |
| 2006 | 100 | 100 | 100 | 97.9 | 80.5 | 35.2 | |
| 2007 | 100 | 100 | 100 | 70 | 77.7 | 41.7 | |
| 2008 | 100 | 100 | 99.7 | 93.4 | 74.7 | 65.8 | |
| | | | | | | | |
| | Jul | Aug | Sep | Oct | Nov | Dec | Total |
| 2005 | 56.9 | 61.2 | 63.8 | 71.1 | 93.4 | 100 | 82 |
| 2006 | 9.3 | 26.6 | 20.3 | 70.2 | 99.9 | 100 | 69.18 |
| 2007 | 41.9 | 34.8 | 55.4 | 88.9 | 98.7 | 100 | 75.7 |
| 2008 | 57.6 | 54.5 | 72.5 | 88.8 | 99.4 | 100 | 83.77 |

**Claims**

1. An air cooling system (400) for a building, comprising:

an air handling unit (410), the air handling unit being adapted to produce cooling air (460) at a predetermined temperature, or within a predetermined range of temperatures, and to supply the cooling air (460) to a space (570) in the building;
a mixing chamber (420), the mixing chamber (420) being adapted to supply air to the air handling unit (410);
a first opening (430) in the mixing chamber (420), the first opening allowing entry into the mixing chamber (420) of a first stream of air (480) from the space (570), the first stream of air (480) being at a temperature above the predetermined temperature;
a second opening (435) in the chamber, the second opening allowing entry into the chamber of a second stream of air (490), the second stream of air coming from outside the building.

2. An air cooling system in accordance with claim 1, wherein:

the air handling unit (410) is a preexisting unit already in use in a building; and
the mixing chamber (420) is retrofitted to the air handling unit.

3. An air cooling system in accordance with claim 1 or claim 2, further comprising:

a selecting mechanism, for selecting the rate of flow of air into the chamber through at least one of the first (430) and second (435) openings.

4. An air cooling system in accordance with claim 3, wherein:

the selecting mechanism is adapted to select the rate of flow of air into the chamber through both the first (430) and second (435) openings.

5. An air cooling system in accordance with claim 3 or claim 4, wherein the selecting mechanism comprises:

a damper (432) located in the first opening (430), the damper providing a variable throttle on the rate of flow of air into the mixing chamber (420) from the space.

6. An air cooling system in accordance with any of claims 2-5, further comprising:

a duct (440) for bringing air from outside the building to the second opening (435);
and wherein the selecting mechanism comprises a fan (350) located in the duct, the rate of turn of the fan determining the rate of flow of air into the mixing chamber (420) from outside the building.

7. An air cooling system in accordance with any of claims 2-5, further comprising:

ducting (640), bringing air from outside the building to more than one air handling unit, the ducting being retrofitted to at least one preexisting unit already in use in the building.

8. An air cooling system in accordance with any of claims 2-7, further comprising:

a control system, the control system being adapted to control the selecting mechanism, and to allow air from outside the building to enter the chamber (420) via the second opening (435) when that air is cooler than the air entering the chamber from the space.

9. An air cooling system in accordance with any previous claim, further comprising:

a control system, the control system having a module adapted to use fuzzy logic to set the mass flow rates of the streams of air flowing to and from the air cooling system, and/or the predetermined temperature or predetermined range of temperatures.

10. An air cooling system in accordance with any previous claim, wherein:

the space (570) is a computer room or a server room;
fans (575) in the ceiling of the computer room or server room are adapted to extract warm air from the computer room, thereby providing the first air stream (580); and cooling air (560) is fed to the computer room or server room via openings (572) that are arranged to deliver the cooling air (560) at multiple locations within the computer room.

**11.** A method of providing air cooling for a space (570) inside a building (615), comprising:

supplying (370, 470) air to an air handling unit (310, 410), the air handling unit providing cooling air (360, 460) at a predetermined temperature to the space (570);
wherein:

(i) when ambient air outside the building is warmer than air extracted from the space, supplying only a stream of air extracted from the space (380, 480) to the air handling unit (310, 410);
(ii) when ambient air outside the building is cooler than air extracted from the space but warmer than the predetermined temperature, supplying to the air handling unit (310, 410) a mixture of a stream of air (380, 480) extracted from the space and a stream of ambient air (390, 490) from outside the building;
(iii) when ambient air outside the building is cooler than the predetermined temperature, supplying to the air handling unit (310, 410) a mixture of a stream of air (380, 480) extracted from the space and a stream of ambient air (390, 490) from outside the building, and reducing the proportion of ambient air in the mixture as the temperature of the ambient air falls.

**12.** A method in accordance with claim 11, further comprising:

retrofitting the mixing chamber to a preexisting air handling unit (410) that is already in use in a building.

**13.** A method in accordance with claim 11 or claim 12, further comprising:

providing ducting (640) to bring air from outside the building to more than one air handling unit, the ducting (640) being retrofitted to at least one preexisting air handling unit already in use in the building.

**14.** A method in accordance with any of claims 11-13, wherein:

in step (ii), the proportion of ambient air in the mixture is kept as close to 100% as possible, and the proportion of air from the space is kept to the minimum necessary to ensure the regulation of humidity in the space (570).

**15.** A method in accordance with any of claims 11-14, wherein:

in step (iii), the proportion (Y) of all the air entering the mixing chamber (420) that originates from the space (570) is given by the relation:

$$Y = T1/(T1-T2)$$

where:
T1 is the difference between the temperature of the air in the stream of ambient air (490) and the predetermined temperature; and
T2 is the difference between the temperature of the stream of air (480) extracted from the space (570) and the predetermined temperature.

100

120

24C

110

130

14C

Fig. 1

Fig. 2

300

390

350

340

335

332

330

320

310

370

380

360

Fig. 3

Fig. 4

Fig. 5

600

690

615

640

620

660

650

680

610

665

670

660

Fig. 6

<u>700</u>

```
                    ┌──────────┐
                    │  Start   │──────────────────────────────┐
                    └──────────┘                              │
                          │                                   │
                          ▼                                   │
                       ◇ Is                      No    ┌──────────────┐
  710 ──────────   Ambient air temp <  ─────────────►  │ Switch off   │
                  temp in space ◇                      │ fan 350      │
                          │                            │ supplying    │
                          │                            │ ambient air  │
                        Yes                            └──────────────┘
                          │                                       720
                          ▼
             630 ◇ Is Humidity < 75% ◇   ─── No ──►
                          │
                        Yes
                          │
                          ▼
  740 ──   ┌──────────────────────┐
           │ Switch on fan 350,   │
           │ supply ambient air   │
           │ to mixer chamber     │
           └──────────────────────┘
                          │
                          ▼
  750 ──   ┌──────────────────────┐
           │ Regulate room        │
           │ temp via fan 350     │──── Yes ──┐
           │ and damper 332       │
           └──────────────────────┘
                          │
                          ▼
  760 ──   ┌──────────────────────┐
      No   │ Check room set       │
  ◄────────│ point is OK          │
           └──────────────────────┘
```

Fig. 7

Fig. 8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008079138 A1
- WO 2008082378 A1